(19) Europäisches Patentamt
European Patent Office
Office européen des brevets

(11) **EP 2 385 382 A1**

(12) **EUROPÄISCHE PATENTANMELDUNG**

(43) Veröffentlichungstag:
**09.11.2011  Patentblatt 2011/45**

(51) Int Cl.:
*G01R 27/20* (2006.01)  *G01R 31/28* (2006.01)
*G01N 27/02* (2006.01)  *G01N 27/82* (2006.01)

(21) Anmeldenummer: **11450059.8**

(22) Anmeldetag: **05.05.2011**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **07.05.2010  AT 7762010**

(71) Anmelder: **Test-Fuchs GmbH**
**3812 Groß-Siegharts (AT)**

(72) Erfinder: **Strohmer, Andreas**
**Alt Nagelberg 3871 (AT)**

(74) Vertreter: **Sonn & Partner Patentanwälte**
**Riemergasse 14**
**1010 Wien (AT)**

(54) **Verfahren und Vorrichtung zur Messung des Widerstandes an der Übergangsstelle zweier Leiter**

(57) Die Erfindung betrifft ein Verfahren und eine Vorrichtung zur Messung des Widerstandes ($Z_ü$) an der Übergangsstelle (Ü) zweier Leiter (A, B) einer Struktur (X) mehrfach verbundener Leiter mit einer Wechselstromquelle (13) zur Einprägung eines Wechselstromes ($i_{in}$) und Einrichtungen zur Messung des resultierenden Wechselstromes ($i_ü$) und der resultierenden Wechselspannung ($u_ü$) an der Übergangsstelle (Ü) und zur Ermittlung des Widerstandes ($Z_ü$) an der Übergangsstelle (Ü). Zur Erzielung eines möglichst rasch und genau durchführbaren Verfahrens sind zwei Einrichtungen zur Messung des resultierenden Wechselstromes ($i_v$, in) vor und nach der Übergangsstelle (Ü) des ersten Leiters (A) und zwei Einrichtungen zur Messung der resultierenden Wechselspannungen ($u_v$, $u_n$) vor der Übergangsstelle (Ü) am ersten Leiter (A) und nach der Übergangsstelle (Ü) am zweiten Leiter (B) vorgesehen, und ist die Einrichtung zur Ermittlung des Widerstandes ($Z_ü$) an der Übergangsstelle (Ü) zur Bildung der Division der Differenz ($\Delta u$) der gemessenen Wechselspannungen ($u_v$, $u_n$) und der Differenz ($\Delta i$) der gemessenen Wechselströme ($i_v$, in) ausgebildet.

FIG. 2

EP 2 385 382 A1

**Beschreibung**

Die Erfindung betrifft ein Verfahren und eine Vorrichtung zur Messung des Widerstandes an der Übergangsstelle zweier Leiter einer Struktur mehrfach verbundener Leiter, wobei im ersten Leiter ein Wechselstrom eingeprägt und der resultierende Wechselstrom und die resultierende Wechselspannung an der Übergangsstelle gemessen und der Widerstand durch Division der resultierenden Wechselspannung und des resultierenden Wechselstromes an der Übergangsstelle ermittelt wird.

Die Erfindung ist insbesondere auf die Messung der Widerstände an den Übergangsstellen von Leitern einer Flugzeugstruktur gerichtet, aber auch bei der Messung der Übergangswiderstände anderer leitfähiger Strukturen, anwendbar.

Moderne Verkehrsflugzeuge haben eine elektrisch leitfähige Struktur bestehend aus Blechen, Spanten, Trägern und Schienen, welche allesamt leitfähig miteinander verbunden sind. Diese das gesamte Flugzeug durchziehende Struktur stellt in erster Linie die mechanische Stabilität des Flugzeugs sicher. Neben dieser Aufgabe erfüllt die leitfähige Struktur jedoch auch elektrische Aufgaben und dient als Masse-Rückleiter, Blitzableiter, Ableiter für Elektrostatik, zur Abschirmung von elektromagnetischer Strahlung usw.. Um diese elektrischen Aufgaben sicher erfüllen zu können, ist eine durchgehende elektrische Leitfähigkeit der gesamten Struktur zwingend erforderlich. Zu diesem Zweck werden vor der Auslieferung des Flugzeugs und allenfalls auch bei der Wartung sämtliche Übergänge aller Leiter der Struktur vermessen und deren Übergangswiderstände bestimmt. Überschreitet der Übergangswiderstand einen vorgegebenen Grenzwert, muss die Verbindung kontrolliert und gegebenenfalls repariert werden.

Der geplante Airbus A350 weist beispielsweise ca. 7000 derartige Übergangsstellen in der leitfähigen Struktur auf. Dementsprechend zeitaufwändig ist ein Messzyklus.

Bei kontaktbehafteten Messungen ist es zusätzlich erforderlich die allenfalls vorhandene Lackschicht auf den Leitern der elektrisch leitfähigen Struktur vor der Messung zu entfernen und nach der Messung wiederherzustellen. Dadurch wird die ohnedies schon sehr lange Messzeit noch weiter erhöht.

Bei kontaktlosen Messungen ist es zwar nicht erforderlich die allenfalls vorhandene Lackschicht vor der Messung zu entfernen und danach wieder auszubessern, allerdings stellen die üblicherweise sehr niedrigen Übergangswiderstände im Bereich von Bruchteilen von Milliohm (mΩ) eine besondere Herausforderung an die Messung dar. Durch übliche Messverfahren können die zumindest in der Flugzeugindustrie geforderten Genauigkeiten von beispielsweise 5 % üblicherweise nicht eingehalten werden.

Beispielsweise beschreibt die US 2007/0273391 A1 ein Verfahren zur Messung eines Schleifenwiderstandes, wobei die gesamte Impedanz einer Widerstandsschleife kontaktlos gemessen wird. Da bei komplexeren elektrisch leitfähigen Strukturen, wie sie beispielsweise in Flugzeugen vorgesehen sind, nicht gewährleistet werden kann, dass der gesamte Messstrom durch eine einzelne Schleife fließt, ist eine derartige Messung des Schleifenwiderstandes für die Messung der Übergangswiderstände zwischen sämtlichen Leitern der Struktur nicht zielführend.

Die Aufgabe der vorliegenden Erfindung besteht daher in der Schaffung eines oben genannten Verfahrens und einer oben genannten Vorrichtung zur Messung des Widerstandes an der Übergangsstelle zweier Leiter einer Struktur mehrfach verbundener Leiter, welche eine rasche, einfache und zerstörungsfreie Messung bei möglichst hoher Genauigkeit zulässt. Nachteile bekannter Verfahren bzw. Vorrichtungen sollen vermieden oder zumindest reduziert werden.

Gelöst wird die erfindungsgemäße Aufgabe in verfahrensmäßiger Hinsicht dadurch, dass der resultierende Wechselstrom an der Übergangsstelle durch Bildung der Differenz der vor und nach der Übergangsstelle des ersten Leiters gemessenen Wechselströme ermittelt wird und die resultierende Wechselspannung an der Übergangsstelle durch Bildung der Differenz der vor der Übergangsstelle am ersten Leiter gemessenen Wechselspannung und der nach der Übergangsstelle am zweiten Leiter gemessenen Wechselspannung ermittelt wird. Durch die Messung der Ströme vor und nach der Übergangsstelle kann der tatsächlich über die Übergangsstelle der beiden Leiter fließende Strom und die entsprechende Spannungsdifferenz mit hoher Genauigkeit ermittelt und daraus der Übergangswiderstand berechnet werden. Durch die Messung des Stromes nach der Übergangsstelle kann der sogenannte Falschstrom, welcher nicht über die Übergangsstelle zwischen den beiden Leitern fließt, ermittelt und dadurch ein genaueres Messergebnis erzielt werden.

Insbesondere wenn die Leiter der elektrisch leitfähigen Struktur, beispielsweise durch eine Lackschicht, isoliert sind, ist es von Vorteil, dass der Wechselstrom am ersten Leiter kontaktlos über eine mit einer Stromquelle verbundene Einspeisezange eingeprägt wird. Alternativ dazu kann auch an ohnedies abisolierten Stellen der Struktur eine Klemme angebracht werden und der Strom über diese Klemme kontaktbehaftet in die Leiterstruktur eingespeist werden.

Um eine zerstörungsfreie und rasche Messung bei isolierten Leitern zu ermöglichen, werden die resultierenden Wechselströme vor und nach der Übergangsstelle bevorzugterweise ebenfalls kontaktlos mittels zweier Strommesszangen gemessen.

Auch die resultierenden Wechselspannungen vor und nach der Übergangsstelle werden vorzugsweise kontaktlos mittels zweier kapazitiver Sensoren gemessen. Da somit vor bzw. nach der Messung keinerlei Arbeit an der Leiterstruktur, wie das Abkratzen bzw. wiederaufbringen der Lackschicht, vorgenommen werden muss, kann die Messung vergleichsweise rasch durchgeführt werden.

Noch genauere Messergebnisse können dadurch erzielt werden, dass eine Referenzspannung, vorzugsweise kontaktlos, über einen kapazitiven Sensor bei ausgeschaltetem eingeprägten Wechselstrom gemessen wird.

Durch diese Referenzspannung können bei der Messung auftretende Phasenverschiebungen und Amplitudenfehler ermittelt und entsprechend korrigiert werden. Durch diese Maßnahme können die hohen Genauigkeitsanforderungen, insbesondere im Flugzeugbau, erfüllt werden.

Um Messfehler zu vermeiden, welche durch inkorrekte Anwendung der kapazitiven Sensoren zur Messung der resultierenden Wechselspannungen auftreten können, ist es von Vorteil, wenn der Anpressdruck der kapazitiven Sensoren während der Messung der resultierenden Wechselspannungen vor und nach der Übergangsstelle und allenfalls der Messung der Referenzspannung im Wesentlichen konstant gehalten wird. Dies kann durch verschiedene mechanische Maßnahmen, wie z.B. den Einsatz von Klemmen, aber auch durch elektronische Maßnahmen, wie das Vorsehen von Drucksensoren, ermittelt und kontrolliert werden.

Zu Zwecken der Qualitätskontrolle und Dokumentation ist es von Vorteil, wenn die Messwerte gespeichert werden.

Für einige Anwendungen kann der komplexe Übergangswiderstand der Übergangsstelle als Ergebnis ausreichen, indem die errechnete Wechselspannungsdifferenz durch die errechnete Wechselstromdifferenz an der Übergangsstelle ohne Berücksichtigung der Phase dividiert wird. Von Vorteil ist es jedoch, wenn der ohmsche Widerstand durch Division der errechneten Wechselspannungsdifferenz und der Wechselstromdifferenz an der Übergangsstelle der beiden Leiter unter Berücksichtigung der Phasenverschiebung berechnet wird. Die Berechnung erfolgt vorzugsweise in einem Mikroprozessor unmittelbar während der Durchführung der Messung, sodass die Ergebnisse sofort angezeigt werden können.

Gemäß einem weiteren Merkmal der Erfindung ist vorgesehen, dass der Betrag des ohmschen Widerstandes und der Phasenverschiebungswinkel berechnet und an einer Anzeige dargestellt werden. Alternativ zur Darstellung der Werte für den ohmschen Übergangswiderstand kann beispielsweise auch nur das Überschreiten eines vorgegebenen Grenzwertes optisch und allenfalls auch akustisch angezeigt werden.

Aufgrund der besonders niedrigen Übergangswiderstände ist es von Vorteil, wenn der eingeprägte Wechselstrom eine Amplitude von 5 A bis 50 A aufweist. Zur Erzielung einer optimalen kontaktlosen Messung bei gleichzeitig geringem Messaufwand ist es von Vorteil, wenn der eingeprägte Wechselstrom eine Frequenz zwischen 400 Hz und 10 kHz aufweist. Für die kapazitive Kopplung ist eine höhere Frequenz vorteilhaft, allerdings treten dann durch die bei diesen Frequenzen auftretenden Serieninduktivitäten der Leiter und die Phasengänge der Strommesszangen Probleme auf.

Gelöst wird die erfindungsgemäße Aufgabe auch durch eine oben genannte Vorrichtung zur Messung des Übergangswiderstandes, wobei zwei Einrichtungen zur Messung des resultierenden Wechselstromes vor und nach der Übergangsstelle des ersten Leiters und zwei Einrichtungen zur Messung der resultierenden Wechselspannungen vor der Übergangsstelle am ersten Leiter und nach der Übergangsstelle am zweiten Leiter vorgesehen sind und die Einrichtung zur Ermittlung des Widerstandes an der Übergangsstelle zur Bildung der Division der Differenz der gemessenen Wechselspannungen und der Differenz der gemessenen Wechselströme ausgebildet ist.

Zu den Vorteilen dieser Messvorrichtung und den Variationsmöglichkeiten wird auf die obige Beschreibung zum Verfahren verwiesen.

Die vorliegende Erfindung wird anhand der beigefügten Zeichnungen näher erläutert.

Darin zeigen:

Fig. 1 eine perspektivische Ansicht einer elektrisch leitfähigen Struktur, wie sie beispielsweise in einem Verkehrsflugzeug vorgesehen ist;

Fig. 2 eine Prinzipskizze des erfindungsgemäßen Messverfahrens;

Fig. 3 ein Schema zur Erläuterung der Berechnung des komplexen Übergangswiderstandes;

Fig. 4 ein Blockschaltbild einer Ausführungsform einer erfindungsgemäßen Messvorrichtung; und

Fig. 5 ein Flussdiagramm zur Erläuterung einer Ausführungsform des erfindungsgemäßen Messverfahrens.

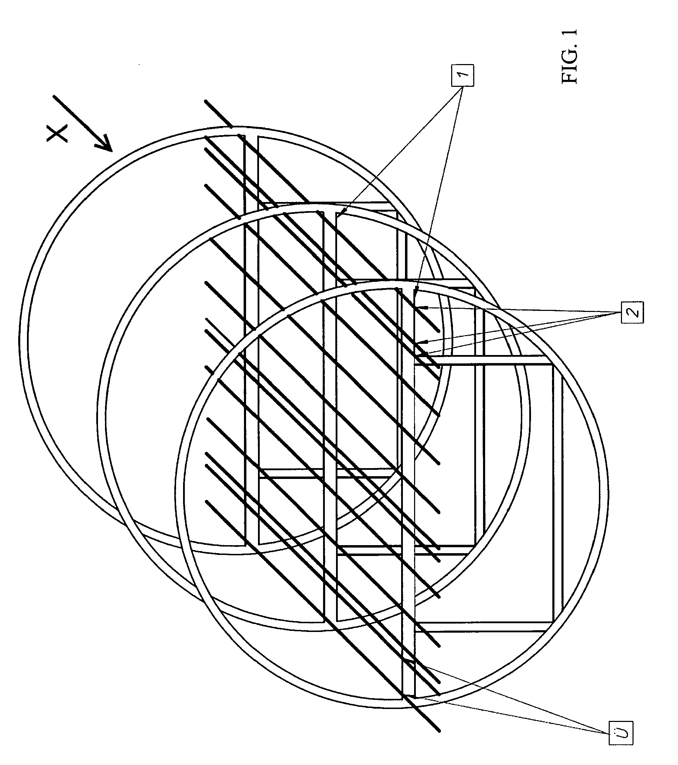

Fig. 1 zeigt eine perspektivische Ansicht einer möglichen Leiterstruktur X, die beispielsweise in einem Verkehrsflugzeug vorgesehen ist. Dementsprechend sind auf parallel angeordneten metallischen Trägern 1 verschiedene Schienen 2 in Richtung der Längsausdehnung des Flugzeugs angeordnet und mit diesen, beispielsweise durch Nieten oder Schrauben verbunden. Schon allein bei dem dargestellten Ausschnitt einer solchen Struktur X, welche quer zum Flugzeugrumpf vorgesehene Spante nicht berücksichtigt, ist die Anzahl an Übergangsstellen Ü relativ hoch. Dementsprechend hoch ist auch der Aufwand für die Messung der Widerstände sämtlicher Übergangsstellen Ü der Struktur X.

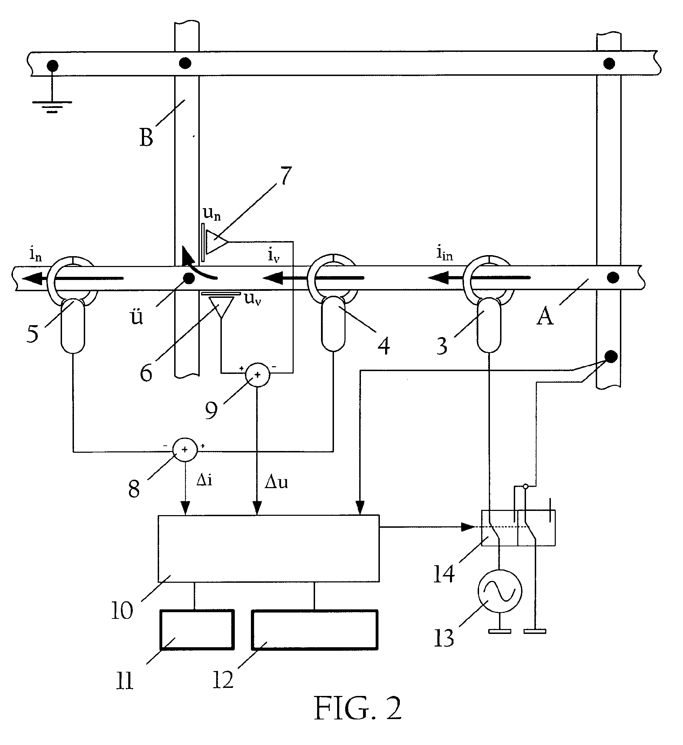

Fig. 2 zeigt nun eine Prinzipskizze der erfindungsgemäßen Messvorrichtung bei der Messung des Übergangswiderstandes $Z_{\ddot{u}}$ an der Übergangsstelle Ü zweier Leiter A, B einer Struktur X mehrfach verbundener elektrischer Leiter. Dabei wird ein Wechselstrom $i_{in}$ vorzugsweise kontaktlos über eine Einspeisezange 3 in den Leiter A eingeprägt. Vor und nach der Übergangsstelle Ü wird vorzugsweise ebenfalls kontaktlos mittels zweier Strommesszangen 4, 5 der resultierende Wechselstrom $i_v$ vor und der resultierende Wechselstrom in nach der Übergangsstelle Ü des ersten Leiters A gemessen. Darüber hinaus wird mit Hilfe von kapazitiven Sensoren 6, 7 die resultierende Wechselspannung $u_v$ vor der Übergangsstelle Ü am ersten Leiter A und die resultierende Wechselspannung $u_n$ nach der Übergangsstelle Ü am zweiten Leiter B ermittelt. Vorzugsweise über entsprechende Differenzverstärker 8, 9 und eine entsprechende Ermittlungseinrichtung 10 werden die Wechselstromdifferenzen $\Delta i = i_v - i_n$ und die Wechselspannungsdifferenzen $\Delta u = u_n - u_v$ an der Übergangsstelle Ü und schließlich daraus der Übergangswiderstand $Z_{\ddot{u}}$ an der Übergangsstelle Ü ermittelt. Die Messwerte sowie die Messergebnisse können in einem Speicher 11 gespeichert werden. Über eine Anzeige 12 wird das Ergebnis des Übergangswiderstandes $Z_{\ddot{u}}$ angezeigt. Die Wechselstromquelle 13 zur Erzeugung des einzuprägenden Wechselstromes $i_{in}$ ist vorzugsweise zur Erzeugung eines Wechselstromes $i_{in}$ mit einer Amplitude zwischen 5 A und 50 A und mit einer Frequenz zwischen 400 Hz und 10 kHz ausgebildet. Über einen Umschalter 14 kann der eingeprägte Wechselstrom $i_{in}$ abgeschaltet werden und eine Referenzspannung $u_{ref}$ zur Ermittlung und Korrektur von Phasenverschiebungen und Amplitudenfehlern ($\Delta u_v$, $\Delta u_n$) herangezogen werden. Darauf wird weiter unten Bezug genommen.

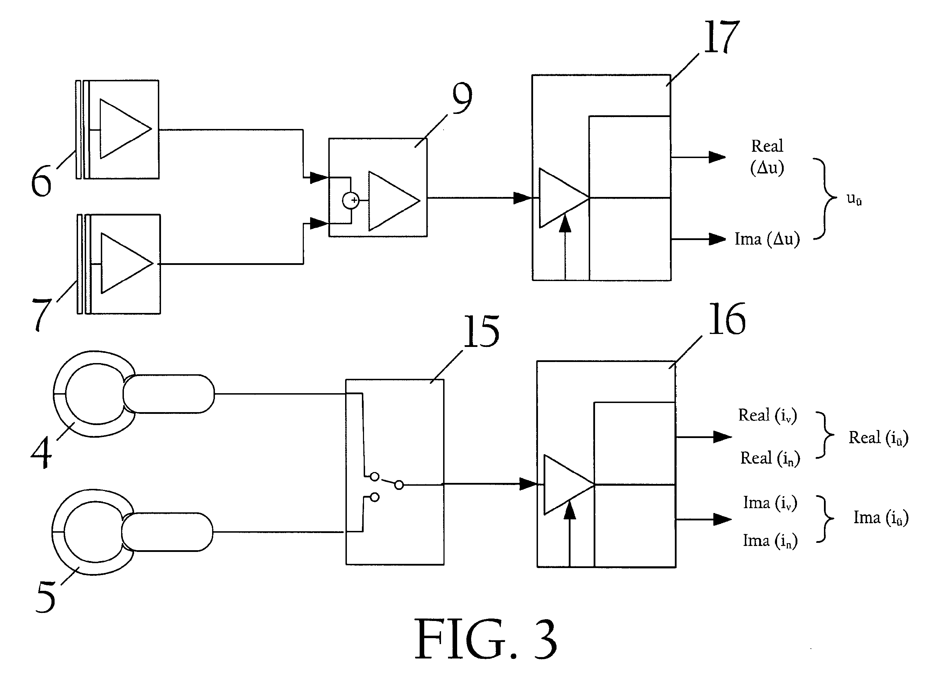

Fig. 3 zeigt eine Prinzipskizze zur Berechnung der Messwerte, wobei die beiden Strommesszangen 4, 5 zur Messung des resultierenden Wechselstromes $i_v$ und in vor bzw. nach der Übergangsstelle Ü dargestellt sind. Weiters zeigt das Prinzipschaltbild die kapazitiven Sensoren 6, 7 zur Messung der resultierenden Wechselspannung $u_v$ vor bzw. der resultierenden Wechselspannung $u_n$ nach der Übergangsstelle Ü. Die Ströme $i_v$, in werden über einen Multiplexer 15 zu einem phasenselektiven Gleichrichter 16 geleitet und die Real- und Imaginärteile des Messstromes (des Wechselstromes $i_v$ vor der Übergangsstelle Ü) und des sogenannten Falschstromes (des Wechselstromes in nach der Übergangsstelle Ü) ermittelt. Die beiden kapazitiven Sensoren 6, 7 zur Messung der resultierenden Wechselspannung $u_v$ vor und der resultierenden Wechselspannung $u_n$ nach der Übergangsstelle Ü sind mit einem Differenzverstärker 9 und einem phasenselektiven Gleichrichter 17 zur Bildung des Real- und Imaginärteils der Wechselspannungsdifferenz $\Delta u$ verbunden.

Aus den erhaltenen Messwerten wird der Strom $i_{\ddot{u}}$ durch die Übergangsstelle Ü wie folgt berechnet:

$$\mathrm{Real}(i_{\ddot{u}}) = \mathrm{Real}(i_v) - \mathrm{Real}(i_n)$$

$$\mathrm{Ima}(i_{\ddot{u}}) = \mathrm{Ima}(i_v) - \mathrm{Ima}(i_n)$$

Daraus folgt:

$$i_{\ddot{u}} = \sqrt{\mathrm{Real}\ (i_{\ddot{u}})^2 + \mathrm{Ima}\ (i_{\ddot{u}})^2}$$

Die Spannung $u_{\ddot{u}}$ an der Übergangsstelle Ü wird folgendermaßen berechnet:

$$\mathrm{Real}(u_{\ddot{u}}) = \mathrm{Real}(\Delta u)$$

$$\mathrm{Ima}(u_{\ddot{u}}) = \mathrm{Ima}(\Delta u)$$

$$u_{\ddot{u}} = \sqrt{\mathrm{Real}\ (u_{\ddot{u}})^2 + \mathrm{Ima}(u_{\ddot{u}})^2}$$

Der Phasenverschiebungswinkel $\Phi_\ddot{u}$ des Übergangswiderstandes $Z_\ddot{u}$ wird folgendermaßen berechnet:

$$\Phi_u = \text{arctan } (\text{Ima}(u_\ddot{u})/\text{Real}(u_\ddot{u}))$$

$$\Phi_i = \text{arctan } (\text{Ima}(i_\ddot{u})/\text{Real}(i_\ddot{u}))$$
$$\rightarrow \Phi_\ddot{u} = \Phi_u - \Phi_i$$

Der Übergangswiederstand folgt aus:

$$Z_\ddot{u} = u_\ddot{u} \ / \ i_\ddot{u}$$

$$R_\ddot{u} = Z_\ddot{u} * \cos (\Phi_\ddot{u})$$

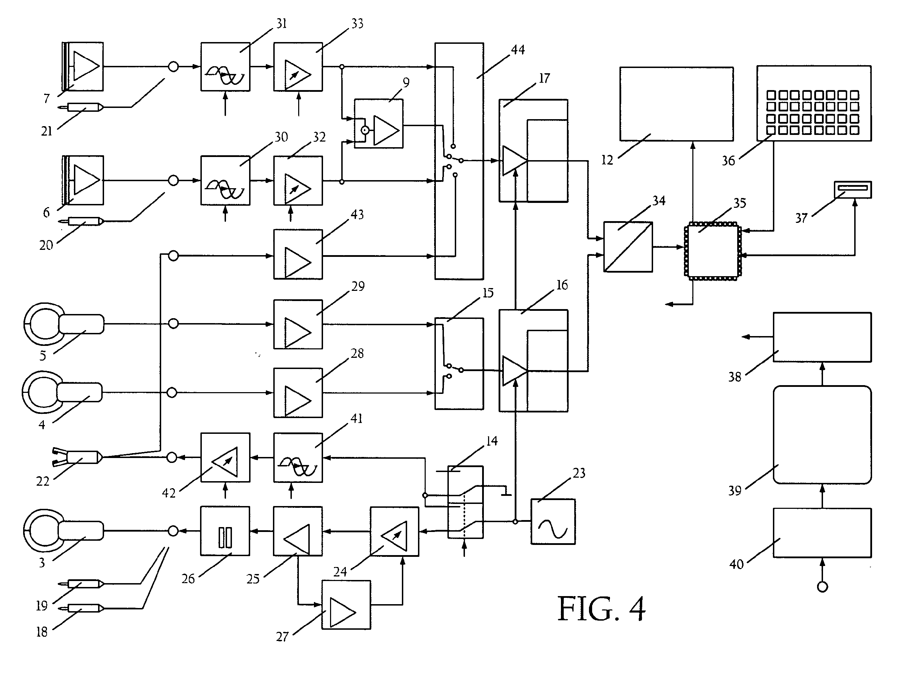

Fig. 4 zeigt ein Blockschaltbild einer möglichen Ausführungsform einer erfindungsgemäßen Messvorrichtung, wobei neben der Einspeisezange 3 und den Strommesszangen 4, 5 und den kapazitiven Sensoren 6, 7 auch Messspitzen 18 bis 21 und Klemmen 22 (im Falle der Verwendung kapazitiver Sensoren 6, 7) dargestellt sind, welche eine kontaktbehaftete Messung, beispielsweise im Falle nicht-isolierter Leiter, ermöglichen. Der einzuspeisende Strom $i_{in}$ wird in einem Frequenzgenerator 23 mit einer bevorzugten Frequenz von 1 kHz bis 10 kHz erzeugt und über den Umschalter 14, einem Vorverstärker 24, einem Leistungsverstärker 25 und einem Transformator 26 zugeführt. Wie bereits oben erwähnt weist der eingeprägte Strom $i_{in}$ vorzugsweise eine Amplitude zwischen 5 A und 50 A auf. Über einen Amplitudenregler 27 kann eine Regelung des Vorverstärkers 24 erfolgen. Die über die Strommesszangen 4, 5 ermittelten Wechselströme $i_v$ und in vor und nach der Übergangsstelle Ü werden Verstärkern 28, 29 und dem bereits erwähnten Multiplexer 15 zugeführt. Im phasenselektiven Gleichrichter 16 erfolgt die Bildung der Real- und Imaginärteile der vor und nach der Übergangsstelle Ü ermittelten Wechselströme $\ddot{u}_v$ und $\ddot{u}_n$. Die über die kapazitiven Sensoren 6, 7 bzw. entsprechenden Messspitzen 20, 21 ermittelten Wechselspannungen $u_v$ und $u_n$ vor und nach der Übergangsstelle Ü werden Phasenschiebern 30, 31 zugeführt und danach, in vorzugsweise justierbaren Verstärkern 32, 33 entsprechend verstärkt. Im Differenzverstärker 9 und dem phasenselektiven Gleichrichter 17 erfolgt die Differenzbildung der beiden Wechselspannungen und die Bildung des Real- und Imaginärteils, wie oben anhand Fig. 3 beschrieben. Die in den phasenselektiven Gleichrichtern 16, 17 ermittelten Messwerte werden in einem Analog-Digital-Konverter 34 digitalisiert und einem Mikroprozessor 35 zur Berechnung des Übergangswiderstandes $Z_\ddot{u}$ zugeführt. Mit dem Mikroprozessor 35 ist die Anzeige 12 zur Darstellung der Werte für den Übergangswiderstand $Z_\ddot{u}$ verbunden. Weiters kann eine Tastatur 36 und eine Schnittstelle 37, vorzugsweise eine USB-Schnittstelle, mit dem Mikroprozessor 35 verbunden sein. Die Messvorrichtung wird über eine Spannungsversorgung 38 mit den notwendigen Betriebsspannungen versorgt. Die Spannungsversorgung 38 ist vorzugsweise mit Akkumulatoren 39 verbunden. Eine entsprechende Ladevorrichtung 40 kann zur Aufladung der Akkumulatoren 39 mit elektrischer Spannung verbunden sein.

Zur Phasenkorrektur und zur Amplitudenkorrektur wird der Umschalter 14 betätigt und somit der eingeprägte Wechselstrom $i_{in}$ abgeschaltet. Der Umschalter 14 ist über einen Phasenschieber 41 und einen Vorverstärker 42 mit der Klemme 22 gekoppelt. Mit Hilfe der Klemme 22 wird eine Referenzspannung $u_{ref}$ gemessen und dem Verstärker 43 und Multiplexer 44 zugeführt.

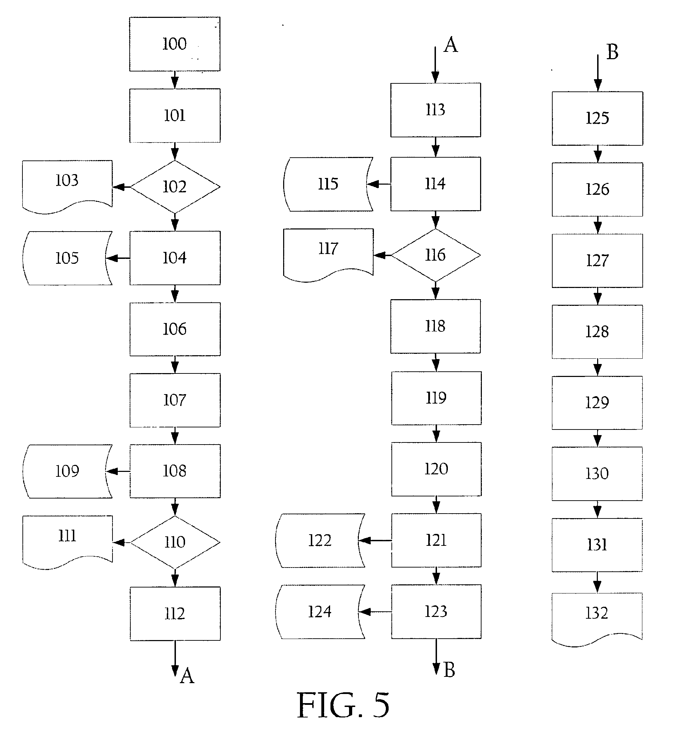

Fig. 5 zeigt ein Flussdiagramm zur Veranschaulichung des erfindungsgemäßen Messverfahrens beginnend mit Schritt 100, dem Einprägen des Wechselstromes $i_{in}$. Gemäß Schritt 101 erfolgt die Messung des Wechselstromes $i_v$ und $i_n$ vor und nach der Übergangsstelle Ü. Bei der Abfrage 102 erfolgt ein Test auf vorgegebene untere bzw. obere Grenzwerte der gemessenen Wechselströme und allenfalls eine entsprechende Fehlermeldung (Schritt 103). Entsprechend Schritt 104 erfolgt die vorzugsweise kontaktlose Messung der Wechselspannungen $u_v$ und $u_n$ vor und nach der Übergangsstelle Ü und eine Speicherung der Messergebnisse gemäß Schritt 105. Schritt 106 sieht das Ausschalten des eingeprägten Wechselstromes $i_{in}$ durch das Umschalten des Umschalters 14 (siehe Fig. 2 und 4) vor. Aufgrund der entsprechenden Messung einer Referenzspannung $u_{ref}$ erfolgt gemäß Schritt 107 eine Justage des Phasenschiebers 41 und Vorverstärkers 42, sodass der kapazitive Sensor 6 ein entsprechendes Signal liefert, wie gemäß Schritt 105 gespeichert. Entsprechend Schritt 108 wird die Referenzspannung $u_{ref}$ über die Klemme 22 gemessen und entsprechend Schritt 109 gespeichert. Gemäß Abfrage 110 werden die ermittelten Spannungswerte auf untere und obere Grenzwerte untersucht und allenfalls gemäß Schritt 111 eine Fehlermeldung ausgegeben. Entsprechend Schritt 112 erfolgt eine Justage des Phasenschiebers 30 und Verstärkers 32 in der Weise, dass der kapazitive Sensor 6 ein entsprechend Schritt 109 gespeichertes Signal liefert. Gemäß Schritt 113 erfolgt dieselbe Justage des Phasenschiebers 41 und des Verstärkers 42, sodass der kapazitive Sensor 7 ein Signal, wie entsprechend Schritt 109 gespeichert, liefert. Danach wird die Referenzspannung $u_{ref}$ entsprechend Schritt 114 gemessen und entsprechend Schritt 115 gespeichert.

Schließlich erfolgt eine weitere Überprüfung der Messwerte auf untere und obere Grenzwerte (siehe Schritt 116) und allenfalls die Ausgabe einer Fehlermeldung (Schritt 117). Schließlich wird gemäß Schritt 118 des Messverfahrens der Phasenschieber 31 und Verstärker 33 so justiert, dass der kapazitive Sensor 7 ein gleich großes Signal, wie entsprechend Schritt 109 gespeichert, liefert.

Entsprechend Schritt 119 wird der Umschalter 14 zurückgeschaltet und wieder der Wechselstrom $i_{in}$ eingeprägt (Schritt 120).

Danach erfolgt die Messung des Wechselstromes $i_v$ und in vor und nach der Übergangsstelle Ü entsprechend Schritt 121 und die Speicherung der Messergebnisse entsprechend Schritt 122.

Schritt 123 sieht die Differenzspannungsmessung $\Delta u$ und Speicherung des Messwertes (Schritt 124) vor.

Gemäß Schritt 125 erfolgt eine Justage der mit den Strommesszangen 4 und 5 verbundenen Verstärker 28 und 29 und des Differenzverstärkers 38 laut gespeicherten Justierkennlinien.

In Schritt 126 wird der Wechselstrom $i_ü$ an der Übergangsstelle Ü durch Differenzbildung zwischen dem Wechselstrom $i_v$ vor und dem Wechselstrom in nach der Übergangsstelle Ü berechnet. In Schritt 127 wird der Übergangswiderstand $Z_ü$ durch Division der Wechselspannungsdifferenz $\Delta u$ durch die Wechselstromdifferenz $\Delta i$ ermittelt. In Schritt 128 wird die Phasenverschiebung $\Phi_u$ der Spannung und in Schritt 129 die Phasenverschiebung $\Phi_i$ des Stromes und in Schritt 130 die Phasenverschiebung $\Phi_ü$ des Übergangswiderstandes $Z_ü$ entsprechend Schritt 131 berechnet und entsprechend Schritt 132 angezeigt.

**Patentansprüche**

1. Verfahren zur Messung des Widerstandes ($Z_ü$) an der Übergangsstelle (Ü) zweier Leiter (A, B) einer Struktur (X) mehrfach verbundener Leiter, wobei im ersten Leiter (A) ein Wechselstrom ($i_{in}$) eingeprägt und der resultierende Wechselstrom ($i_ü$) und die resultierende Wechselspannung ($u_ü$) an der Übergangsstelle (Ü) gemessen und der Widerstand ($Z_ü$) durch Division der resultierenden Wechselspannung ($u_ü$) und des resultierenden Wechselstromes ($i_ü$) an der Übergangsstelle (Ü) ermittelt wird, **dadurch gekennzeichnet, dass** der resultierende Wechselstrom ($i_ü$) an der Übergangsstelle (Ü) durch Bildung der Differenz ($\Delta i$) der vor und nach der Übergangsstelle (Ü) des ersten Leiters (A) gemessenen Wechselströme ($i_v$, in) ermittelt wird, und die resultierende Wechselspannung ($u_ü$) an der Übergangsstelle (Ü) durch Bildung der Differenz ($\Delta u$) der vor der Übergangsstelle (Ü) am ersten Leiter (A) gemessenen Wechselspannung ($u_v$) und der nach der Übergangsstelle (Ü) am zweiten Leiter (B) gemessenen Wechselspannung ($u_n$) ermittelt wird.

2. Verfahren nach Anspruch 1, **dadurch gekennzeichnet, dass** der Wechselstrom ($i_{in}$) am ersten Leiter (A) kontaktlos über eine mit einer Stromquelle verbundene Einspeisezange (3) eingeprägt wird.

3. Verfahren nach Anspruch 1 oder 2, **dadurch gekennzeichnet, dass** die resultierenden Wechselströme ($i_v$, $i_n$) vor und nach der Übergangsstelle (Ü) kontaktlos mittels zweier Strommesszangen (4, 5) und die resultierenden Wechselspannungen ($u_v$, $u_n$) vor und nach der Übergangsstelle (Ü) kontaktlos mittels zweier kapazitiver Sensoren (6, 7) gemessen werden.

4. Verfahren nach einem der Ansprüche 1 bis 3, **dadurch gekennzeichnet, dass** eine Referenzspannung ($u_{ref}$) vorzugsweise kontaktlos über einen kapazitiven Sensor bei ausgeschaltetem eingeprägten Wechselstrom ($i_{in}$) gemessen wird.

5. Verfahren nach Anspruch 4, **dadurch gekennzeichnet, dass** über die Referenzspannung ($u_{ref}$) die Phasenverschiebung ($\Phi$) und der Amplitudenfehler ($\Delta u_v$, $\Delta u_n$) ermittelt und korrigiert wird.

6. Verfahren nach einem der Ansprüche 3 bis 5, **dadurch gekennzeichnet, dass** der Anpressdruck der kapazitiven Sensoren (6, 7) während der Messung der resultierenden Wechselspannungen ($u_v$, $u_n$) vor und nach der Übergangsstelle (Ü) und allenfalls der Messung der Referenzspannung ($u_{ref}$) im Wesentlichen konstant gehalten wird.

7. Verfahren nach einem der Ansprüche 1 bis 6, **dadurch gekennzeichnet, dass** der ohmsche Widerstand ($R_ü$) durch Division der errechneten Wechselspannungsdifferenz ($\Delta u$) und der Wechselstromdifferenz ($\Delta i$) an der Übergangs-

stelle (Ü) der beiden Leiter (A, B) unter Berücksichtigung der Phasenverschiebung ($\Phi_{\ddot{u}}$) berechnet wird.

8.  Verfahren nach Anspruch 7, **dadurch gekennzeichnet, dass** der Betrag des komplexen Widerstandes ($|Z_{\ddot{u}}|$), der Betrag des ohmschen Widerstandes ($|R_{\ddot{u}}|$) und die Phasenverschiebung ($\Phi_{\ddot{u}}$) berechnet und angezeigt werden.

9.  Vorrichtung zur Messung des Widerstandes ($Z_{\ddot{u}}$) an der Übergangsstelle (Ü) zweier Leiter (A, B) einer Struktur (X) mehrfach verbundener Leiter, mit einer Wechselstromquelle zur Einprägung eines Wechselstromes ($i_{in}$) im ersten Leiter (A) und einer Einrichtung (10) zur Messung des resultierenden Wechselstromes ($i_{\ddot{u}}$) und einer Einrichtung zur Messung der resultierenden Wechselspannung ($u_{\ddot{u}}$) an der Übergangsstelle (Ü) und einer Einrichtung zur Ermittlung des Widerstandes ($Z_{\ddot{u}}$) durch Division der resultierenden Wechselspannung ($u_{\ddot{u}}$) und des resultierenden Wechselstromes ($i_{\ddot{u}}$) an der Übergangsstelle (Ü), **dadurch gekennzeichnet, dass** zwei Einrichtungen zur Messung des resultierenden Wechselstromes ($i_v$, $i_n$) vor und nach der Übergangsstelle (Ü) des ersten Leiters (A), und zwei Einrichtungen zur Messung der resultierenden Wechselspannungen ($u_v$, $u_n$) vor der Übergangsstelle (Ü) am ersten Leiter (A) und nach der Übergangsstelle (Ü) am zweiten Leiter (B) vorgesehen sind, und dass die Einrichtung zur Ermittlung des Widerstandes ($Z_{\ddot{u}}$) an der Übergangsstelle (Ü) zur Bildung der Division der Differenz ($\Delta u$) der gemessenen Wechselspannungen ($u_v$, $u_n$) und der Differenz ($\Delta i$) der gemessenen Wechselströme ($i_v$, $i_n$) ausgebildet ist.

10. Vorrichtung nach Anspruch 9, **dadurch gekennzeichnet, dass** die Einrichtung zur Einprägung des Wechselstromes ($i_{in}$) durch eine mit einer Stromquelle (13) verbundene Einspeisezange (3) gebildet ist.

11. Vorrichtung nach Anspruch 9 oder 10, **dadurch gekennzeichnet, dass** die Wechselstrommesseinrichtungen durch Strommesszangen (4, 5) und die Wechselspannungsmesseinrichtungen durch kapazitive Sensoren (6, 7) gebildet sind.

12. Vorrichtung nach einem der Ansprüche 9 bis 11, **dadurch gekennzeichnet, dass** eine Einrichtung zur Messung einer Referenzspannung ($u_{ref}$) bei ausgeschalteter Einrichtung zur Einprägung eines Wechselstromes ($i_{in}$) vorgesehen ist, welche vorzugsweise durch einen kapazitiven Sensor gebildet ist.

13. Vorrichtung nach Anspruch 12, **dadurch gekennzeichnet, dass** die Ermittlungseinrichtung zur Ermittlung und Korrektur der Phasenverschiebung ($\Phi$) und der Amplitudenfehler ($\Delta u_v$, $\Delta u_n$) aus der gemessenen Referenzspannung ($u_{ref}$) ausgebildet ist.

14. Vorrichtung nach einem der Ansprüche 11 bis 13, **dadurch gekennzeichnet, dass** die kapazitiven Sensoren (6, 7) zur Konstanthaltung des Anpressdrucks während der Messung der resultierenden Wechselspannungen ($u_v$, $u_n$) vor und nach der Übergangsstelle (Ü) und allenfalls der Messung der Referenzspannung ($u_{ref}$) ausgebildet sind.

15. Vorrichtung nach einem der Ansprüche 9 bis 14, **dadurch gekennzeichnet, dass** die Ermittlungseinrichtung (10) zur Berechnung des ohmschen Widerstandes ($R_{\ddot{u}}$) an der Übergangsstelle (Ü) durch Division der errechneten Wechselspannungsdifferenz ($\Delta u$) und der Wechselstromdifferenz ($\Delta i$) an der Übergangsstelle (Ü) der beiden Leiter (A, B) unter Berücksichtigung der Phasenverschiebung ($\Phi_{\ddot{u}}$) ausgebildet ist.

16. Vorrichtung nach Anspruch 15, **dadurch gekennzeichnet, dass** eine Anzeige (12) zur Darstellung des Betrags des komplexen Widerstandes ($|Z_{\ddot{u}}|$) des Betrags, des ohmschen Widerstandes ($|R_{\ddot{u}}|$) und der Phasenverschiebung ($\Phi_{\ddot{u}}$) vorgesehen ist.

FIG. 1

FIG. 2

FIG. 3

FIG. 4

FIG. 5

Europäisches
Patentamt

European
Patent Office

Office européen
des brevets

**EUROPÄISCHER RECHERCHENBERICHT**

Nummer der Anmeldung

EP 11 45 0059

| | **EINSCHLÄGIGE DOKUMENTE** | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (IPC) |
| X | ANDREA SCORZONI ET AL: "Methods for contact resistance measurements: application to (n<+>, p<+>) Si/Al-1% Si ohmic contacts", ALTA FREQUENZA,, Bd. 53, Nr. 5, 1. September 1984 (1984-09-01), Seiten 282-286, XP001457933, * Seite 282 - Seite 283, Spalte 2, Absatz 1 * ----- | 1-16 | INV. G01R27/20 G01R31/28 G01N27/02 G01N27/82 |
| A | WO 03/052429 A2 (SIGNUS INC [US]) 26. Juni 2003 (2003-06-26) * Zusammenfassung; Abbildungen 1-3, 8, 9 * * Seite 15, Zeile 22 - Zeile 31 * ----- | 1-16 | |
| A | EP 1 783 501 A2 (BOEING CO [US]) 9. Mai 2007 (2007-05-09) * Zusammenfassung; Abbildung 1 * * Absatz [0001] - Absatz [0002] * ----- | 1-16 | RECHERCHIERTE SACHGEBIETE (IPC) |
| A | US 2004/178790 A1 (GIFFORD CARL B [US] ET AL) 16. September 2004 (2004-09-16) * Zusammenfassung; Abbildungen 1-3 * ----- | 1-16 | G01R G01N |
| A | US 4 048 558 A (GOODMAN CLARK) 13. September 1977 (1977-09-13) * Spalte 2, Zeile 34 - Zeile 39 * ----- | 1-16 | |

Der vorliegende Recherchenbericht wurde für alle Patentansprüche erstellt

| Recherchenort | Abschlußdatum der Recherche | Prüfer |
|---|---|---|
| Berlin | 15. September 2011 | Koll, Hermann |

# EP 2 385 382 A1

**ANHANG ZUM EUROPÄISCHEN RECHERCHENBERICHT
ÜBER DIE EUROPÄISCHE PATENTANMELDUNG NR.**

EP 11 45 0059

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-09-2011

| Im Recherchenbericht angeführtes Patentdokument | | Datum der Veröffentlichung | Mitglied(er) der Patentfamilie | | Datum der Veröffentlichung |
|---|---|---|---|---|---|
| WO 03052429 | A2 | 26-06-2003 | AU | 2002366370 A1 | 30-06-2003 |
| EP 1783501 | A2 | 09-05-2007 | US | 2007096751 A1 | 03-05-2007 |
| | | | US | 2008061774 A1 | 13-03-2008 |
| US 2004178790 | A1 | 16-09-2004 | EP | 1604199 A1 | 14-12-2005 |
| | | | JP | 4275173 B2 | 10-06-2009 |
| | | | JP | 2006520477 A | 07-09-2006 |
| | | | WO | 2004083845 A1 | 30-09-2004 |
| US 4048558 | A | 13-09-1977 | KEINE | | |

Für nähere Einzelheiten zu diesem Anhang : siehe Amtsblatt des Europäischen Patentamts, Nr.12/82

EPO FORM P0461

14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20070273391 A1